# EUROPEAN PATENT APPLICATION

(11) **EP 4 431 407 A1**
(43) Date of publication of application: **18.09.2024**
(21) Application number: 23768106.9
(22) Date of filing: 17.04.2023

(54) **SEPARATION PLATE, TRAY ASSEMBLY, AND BATTERY PROCESSING DEVICE**

(30) Priority: 31.01.2023 CN 202320088598 U
(71) Applicant: Contemporary Amperex Technology Co., Limited, Ningde, Fujian 352100 (CN)
(72) Inventor: ZHAO, Jiayi, Ningde, Fujian 352100 (CN); HUANG, Fangyu, Ningde, Fujian 352100 (CN); WANG, Zhihui, Ningde, Fujian 352100 (CN)
(74) Representative: Ran, Handong
(86) International application number: PCT/CN2023/088735
(87) International publication number: WO 2024/159629

(57) **Abstract**

This application discloses a spacer, a tray assembly, and a battery processing device. The spacer includes a plate body and a restraint member. The plate body has a first surface. The restraint member is connected to the plate body and extends along a direction leaving the first surface. The restraint member is configured to limit a position on an outer side of a battery cell, to block the battery cell from moving along the direction leaving the first surface. In this application, the restraint member is configured to limit a position of the battery cell to block the battery cell from moving along the direction leaving the first surface, so that the battery cell is limited between the first surface and the restraint member. In this way, when an external force disappears, a possibility of displacement of the battery cell is reduced by the restraint member, so that the battery cell can remain at a predetermined position on the spacer, thereby improving stability of the battery cell.

## Description

### CROSS-REFERENCE TO RELATED APPLICATIONS

This application claims priority to Chinese Patent Application No. 202320088598.9, filed on January 31, 2023 and entitled "SPACER, TRAY ASSEMBLY, AND BATTERY PROCESSING DEVICE", which is incorporated herein by reference in its entirety.

### TECHNICAL FIELD

This application relates to the field of battery processing, and in particular, to a spacer, a tray assembly, and a battery processing device.

### BACKGROUND

During battery processing, to perform processing such as formation on a battery, the battery usually needs to be fastened on a tray, and the tray is transported to a predetermined device for processes such as formation. To facilitate fastening of batteries, in some cases, the batteries are usually stacked and clamped by an external force in a predetermined direction to keep the batteries stable. When the external force applied to the batteries disappears, the stacked batteries are prone to displacement, causing disorder of positions of the batteries or even causing some batteries to fall over.

### SUMMARY

Amain objective of this application is to propose a spacer, so as to alleviate an existing problem that a battery cell is prone to displacement.

To achieve the foregoing objective, this application proposes a spacer for mounting a battery cell. The spacer includes:
a plate body, where the plate body has a first surface; and
a restraint member, connected to the plate body and extending along a direction leaving the first surface, where the restraint member is configured to limit a position on an outer side of the battery cell, to block the battery cell from moving along the direction leaving the first surface.

In this example, the restraint member is configured to limit a position of the battery cell to block the battery cell from moving along the direction leaving the first surface, so that the battery cell is limited between the first surface and the restraint member. In this way, when an external force disappears, displacement of the battery cell is reduced by the restraint member, so that the battery cell can remain at a predetermined position on the spacer, thereby improving stability of the battery cell.

In some examples, the restraint member includes:
a connecting section, connected to the plate body and extending along the direction leaving the first surface; and
a restraint section, connected to an end of the connecting section that is away from the first surface, and at an included angle with the connecting section, where the restraint section is provided with a restraint surface, a mounting position for mounting the battery cell is formed between the restraint surface and the first surface, and the restraint surface is configured to block the battery cell from moving along the direction leaving the first surface.

In this example, the connecting section is connected to the plate body, and the restraint surface is formed by the restraint section, so that the mounting position for mounting the battery cell can be formed between the restraint surface of the restraint member and the first surface. The restraint section is at an included angle with the connecting section, so that the restraint member is generally in an L shape, and the restraint surface can be formed, to implement fitting between the restraint member and the first surface, and reduce movement of the battery cell along the direction leaving the first surface.

In some examples, two restraint members are provided, and the two restraint members are spaced apart; and
restraint sections of the two restraint members separately extend along directions facing each other.

In this example, the two restraint members are spaced apart along the first direction, so that space for accommodating the battery cell is formed between the two restraint members. Because the two restraint members separately extend along directions facing each other, the two restraint members each form a restraint surface for limiting a position of the battery cell on an outer side of the first surface, to limit two ends of the battery cell in the first direction, thereby improving the stability of the battery cell while reducing movement of the battery cell along the direction leaving the first surface.

In some examples, the two restraint members are spaced apart along a first direction, the plate body has a first end and a second end that are provided opposite to each other in a second direction, the restraint member has a first end provided in the second direction, and the first end of the restraint member is located on a same side of the spacer as the first end of the plate body; and
the first end of the plate body extends beyond the first end of the restraint member along the second direction, where the second direction intersects with the first direction.

In this example, a distance between the first end of the restraint member and the second end of the plate body is less than a distance between the first end and the second end of the plate body, so that the first end of the restraint member is lower than the first end of the plate body, and an outer surface of the battery cell can be pressed against on a side of the first end of the restraint member when the battery cell is gripped, thereby facilitating movement of the battery cell.

In some examples, a distance between the first end and the second end of the plate body is Li, a distance between the first end of the restraint member and the first end of the plate body is L₂, and 0.2L₁ ≤ L₂ ≤ 0.3L₁.

In this example, the distance between the first end of the plate body and the first end of the restraint member is limited, so that the spacer has a sufficient margin on the side of the first end of the restraint member. In this way, when the battery cell is gripped, a gripping apparatus and the battery cell can have a sufficiently large contact area, to prevent the battery cell from falling off during gripping.

In some examples, the restraint surface is parallel to the first surface. The restraint surface is parallel to the first surface, so that two opposite outer surfaces of the battery cell can be attached to the first surface and the restraint surface respectively, to increase a contact area between the first surface and the battery cell and a contact area between the restraint surface and the battery cell, and improve stability of the battery cell.

In some examples, the restraint member is integrated with the plate body. The restraint member is integrated with the plate body, so that structural stability of the restraint member and the plate body is improved. Because the restraint member can be directly integrated with the plate body, processing steps of the spacer can be simplified, and processing efficiency of the spacer can be improved.

In some examples, the plate body further has a second surface, the second surface is provided opposite to the first surface in a third direction, and the third direction is a thickness direction of the plate body; and
the spacer further includes a cushion, the first surface is provided with the cushion, and the second surface is provided with the cushion, where in some examples, the first surface is provided with the cushion, or in some examples, the second surface is provided with the cushion.

In this example, the cushion is provided on the second surface of the spacer. When adjacent spacers are combined along the third direction, the cushion can act on battery cells on the adjacent spacers, to provide elastic cushioning for the battery cell, reduce indentation on surfaces of the battery cells when the battery cells are gripped, and avoid extrusion damage to the battery cells.

In some examples, at least one edge part of the cushion is provided with a second chamfer. In this example, the second chamfer is provided on the cushion, so that the battery cell can be placed in the mounting position.

In some examples, the restraint member is provided at an end of the plate body in the first direction, and the cushion has an inner surface facing the plate body and an outer surface facing away from the plate body;
the cushion further has a first outer wall provided in the second direction, where the second direction intersects with the first direction; and
the inner surface of the cushion is connected to the first outer wall, the second chamfer is provided between the first outer wall and the outer surface of the cushion, and in a projection in the second direction, a length of a projection of the first outer wall is less than a length of a projection of the second chamfer.

In this example, a width of the second chamfer is greater than a width of the first outer wall, so that an extension distance of the second chamfer can be increased, and the battery cell can be guided by the second chamfer, to facilitate placement of the battery cell.

In some examples, the plate body further has a second surface, the second surface is provided opposite to the first surface in a third direction, and the third direction is a thickness direction of the plate body; and
the second surface is provided with an avoidance groove, and in a projection in the third direction, a projection of the restraint section falls within a projection of the avoidance groove.

The avoidance groove is provided, so that when a plurality of spacers are combined, restraint sections of the spacers can be accommodated in avoidance grooves on adjacent spacers. In this way, second surfaces of the adjacent spacers can limit positions of battery cells, to reduce a possibility of movement of the battery cells along a direction leaving first surfaces.

In some examples, the two restraint members are spaced apart along the first direction, and the spacer further includes:
a support member, connected to the plate body, where the support member is provided on a side of the plate body in the second direction, and an included angle is formed between the second direction and the first direction.

In this example, the support member may be configured to support the plate body, to keep the plate body at a predetermined height position. In this way, the spacer can be supported at a predetermined position on an external device, to facilitate positioning of the spacer and the battery cell.

This application further proposes a tray assembly, including:
a tray;
the spacer in any one of the foregoing examples, provided on the tray; and
a fastening block, provided on the tray, where the spacer is connected to the fastening block.

In this example, a position of the spacer is limited by the fastening block, so that the spacer is retained at a predetermined position on the tray, to fasten the spacer. In this way, the tray assembly can be used to limit a position of the battery cell.

In some examples, one of the plate body and the fastening block is provided with a clamping groove, the other is provided with an elastic buckle, and the elastic buckle is elastically clamped in the clamping groove. The elastic buckle is provided, so that the plate body can be fastened to the fastening block, thereby facilitating mounting and removal of the spacer, and improving flexibility of assembly and disassembly of the structure.

In some examples, the fastening block is provided with a guide groove on a side facing the plate body, and the plate body is slidably disposed in the guide groove.

In this example, the plate body is slidably disposed in the guide groove, so that a movement direction of the plate body can be limited by the guide groove, and the plate body and the fastening block can fit with each other only along an extension direction of the guide groove, thereby improving relative stability of the plate body and the fastening block.

This application further proposes a battery processing device, including the tray assembly in any one of the foregoing examples.

In this example, a position of a battery cell is limited a spacer, to reduce unnecessary movement of the battery cell. This can effectively improve stability of the battery cell during processing of the battery cell, to facilitate control on battery processing parameters and improve product quality.

### BRIEF DESCRIPTION OF DRAWINGS

To describe the technical solutions in the examples of this application or in the prior art more clearly, the following briefly describes the accompanying drawings required for describing the embodiments or the prior art. Apparently, the accompanying drawings in the following description show merely some of the embodiments of this application, and a person of ordinary skill in the art may still derive other drawings from the structures shown in these accompanying drawings without creative efforts.
FIG. 1 is a top view of an example of a tray assembly according to this application;
FIG. 2 is a schematic structural diagram of an example of a fastening block according to this application;
FIG. 3 is a left view of an example of a tray assembly according to this application;
FIG. 4 is a schematic structural diagram of an example of a plate body on a side of a first surface according to this application;
FIG. 5 is a top view of an example of a plate body according to this application;
FIG. 6 is a schematic structural diagram of an example of a plate body in use on a side of a first surface according to this application;
FIG. 7 is a schematic exploded view of an example of a spacer and a battery cell in fit according to this application;
FIG. 8 is a top view of an example of a battery cell in a gripped state according to this application;
FIG. 9 is a schematic structural diagram of an example of a plate body on a side of a second surface according to this application;
FIG. 10 is a schematic structural diagram of an example of a cushion on a side of an inner surface according to this application; and
FIG. 11 is a schematic structural diagram of an example of a cushion on a side of an outer surface according to this application.

### Descriptions of reference signs:

| Reference sign | Name | Reference sign | Name |
|---|---|---|---|
| 10 | Tray | 11 | Drive member |
| 111 | Push plate | 112 | Drive rod |
| 113 | End plate | 12 | Fastening block |
| 121 | Convex portion | 122 | Concave portion |
| 123 | Clamping groove | 124 | Guide groove |
| 20 | Battery cell | 30 | Spacer |
| 31 | Plate body | 311 | First surface |
| 312 | Second surface | 313 | Avoidance groove |
| 314 | Second lightening hole | 315 | Positioning hole |
| 32 | Restraint member | 321 | Connecting section |
| 322 | Restraint section | 323 | Restraint surface |
| 324 | First stiffener | 325 | First chamfer |
| 33 | Cushion | 331 | Boss |
| 332 | Second chamfer | 34 | Support member |
| 341 | Bearing surface | 342 | Via hole |
| 343 | Second stiffener | 344 | First lightening hole |
| 35 | Elastic buckle | 351 | Elastic beam |
| 352 | Clamping protrusion | 353 | Clearance groove |
| 36 | First outer wall | 37 | Mounting position |
| 4a | First direction | 4b | Second direction |
| 4c | Third direction | | |

Objective achievement, functional features, and advantages of this application are further described with reference to the embodiments and the accompanying drawings.

### DESCRIPTION OF EMBODIMENTS

The following clearly and completely describes the technical solutions in the examples of this application with reference to the accompanying drawings in the examples of this application. Apparently, the described embodiments are only some but not all of the embodiments of this application. All other embodiments obtained by persons of ordinary skill in the art based on the embodiments of this application without creative efforts shall fall within the protection scope of this application.

It should be noted that, if a directional indication (such as up, down, left, right, front, or back) is included in the examples of this application, the directional indication is only intended to explain a relative position relationship, a movement status, or the like between components examples of specific attitude (as shown in the accompanying drawings), and if the specific attitude changes, the directional indication changes correspondingly.

In addition, if descriptions such as "first" and "second" are included in the examples of this application, the descriptions such as "first" and "second" are merely intended for a purpose of description, and shall not be construed as an indication or implication of relative importance or an implicit indication of the number of indicated technical features. Therefore, a feature defined by "first" or "second" may explicitly or implicitly include at least one such feature. In addition, technical solutions in various embodiments may be combined with each other, provided that the combination can be implemented by a person of ordinary skill in the art. When combined technical solutions are contradictory or the combination cannot be implemented, it should be considered that this combination of technical solutions does not exist, and does not fall within the protection scope claimed in this application.

In this application, "a plurality of" means more than two (inclusive).

The battery cell in this application may include a secondary battery, a primary battery, a lithium-sulfur battery, a sodium-lithium-ion battery, a sodium-ion battery, a magnesium-ion battery, or the like. This is not limited in the examples of this application. The battery cell may be in a cylindrical shape, a flat shape, a cuboid shape, or another shape. This is not limited in the examples of this application either. Battery cells are usually classified into three types based on a packaging method: a cylindrical battery cell, a prismatic battery cell, and a pouch battery cell. This is not limited in the examples of this application either.

The battery mentioned in the embodiments of this application is a single physical module that includes one or more battery cells for providing a higher voltage and capacity. For example, the battery mentioned in this application may include a battery module or a battery pack. A battery usually includes a box for enclosing one or more battery cells or a plurality of battery modules. The box can prevent liquids or other foreign matter from affecting charging or discharging of the battery cell.

The battery cell includes a housing, an electrode assembly, and an electrolyte, where the housing is configured to accommodate the electrode assembly and the electrolyte. The electrode assembly includes a positive electrode plate, a negative electrode plate, and a separator. Working of the battery cell mainly relies on migration of metal ions between the positive electrode plate and the negative electrode plate. The positive electrode plate includes a positive electrode current collector and a positive electrode active substance layer. The positive electrode active substance layer is applied on a surface of the positive electrode current collector. The part of positive electrode current collector uncoated with the positive electrode active substance layer protrudes out of the part of positive electrode current collector coated with the positive electrode active substance layer and serves as a positive tab. A lithium-ion battery is used as an example, for which, the positive electrode current collector may be made of aluminum and the positive electrode active substance may be lithium cobaltate, lithium iron phosphate, ternary lithium, lithium manganate, or the like. The negative electrode plate includes a negative electrode current collector and a negative electrode active substance layer. The negative electrode active substance layer is applied on a surface of the negative electrode current collector. The part of negative electrode current collector uncoated with the negative electrode active substance layer protrudes out of the part of negative electrode current collector coated with the negative electrode active substance layer and serves as a negative tab. The negative electrode current collector may be made of copper, and the negative electrode active substance may be carbon, silicon, or the like. To allow a large current to pass through without any fusing, multiple positive tabs are provided and stacked together, and multiple negative tabs are provided and stacked together. The separator may be made of PP (polypropylene, polypropylene), PE (polyethylene, polyethylene), or the like. In addition, the electrode assembly may have a wound structure or a laminated structure. The examples of this application are not limited thereto.

With development of battery technologies, batteries have been widely used in work and daily life. Batteries can be found everywhere, for example, in mobile phones and new energy vehicles. During preparation of an electrode assembly of a battery cell, slurry preparation, coating, cold pressing, winding, hot pressing, assembly, liquid injection, and formation need to be performed in some preparation processes.

To facilitate fastening of the battery cell during preparation of the battery cell, in some cases, a tray is provided at the bottom of the battery cell, to provide support for the battery cell through the tray. During movement of the battery cell between different process devices, the tray supports a bottom surface of the battery cell to keep the battery cell in a predetermined form. During operation of a process device, the battery cell needs to remain in the predetermined form for predetermined time, to cooperate with the process device to implement a corresponding processing step.

During movement of the battery cell between different process devices, the battery cell may be affected by an external force, and the battery cell may move or even fall over due to instability of a center of gravity, affecting normal operation of a process, and therefore directly affecting processing quality of the battery cell.

In view of the foregoing problem that the battery cell is prone to displacement and fall-over during processing, the inventor proposes a spacer. A restraint member is provided on the spacer, to limit a position of the battery cell through fitting between the restraint member and the spacer, so that the battery cell can remain at a predetermined position, and the problem of displacement of the battery cell is alleviated. In the spacer, the restraint member fits with a plate body to limit the battery cell at the predetermined position, so that the battery cell can remain in a predetermined state at the predetermined position. In this way, a position of the battery cell is limited during movement of the battery cell between different process devices or during processing of the battery cell, so that the battery cell can remain in a stable state, to facilitate processing steps.

The spacer disclosed in the examples of this application may be used in a variety of processes of a battery processing device, including but not limited to assembly, liquid injection, formation, and the like. With the spacer disclosed in this application, after the battery cell is mounted to the spacer, the battery cell is limited at the predetermined position, so that the battery cell can remain in a predetermined posture at the predetermined position. In this way, the battery cell can remain in a stable state during each process and during movement of the battery cell between different processes, so that processing efficiency of the battery cell can be improved.

In the following example, an example in which a battery processing device in an example of this application is a liquid injection device is used for ease of description.

During a liquid injection process, in some process methods, the battery is placed upside down at a predetermined position on a liquid injection plate, and the battery cell is pressed against and sealed with the liquid injection plate. A liquid injection hole and a liquid injection box used for liquid injection form sealed space inside the battery cell, and the liquid injection box is vacuumed. After negative pressure is formed inside the battery cell, a liquid injection valve is opened, and electrolyte flows into the liquid injection box due to an air pressure difference. The liquid injection valve is closed after liquid injection is completed. In this example, the spacer can be used to limit a position of the battery cell. After the battery cell is placed on the spacer, the battery cell is limited at the predetermined position by the spacer and the restraint member on the spacer, so that the battery cell remains in the predetermined posture. This facilitates alignment between the liquid injection plate and the liquid injection hole of the battery cell during liquid injection, and therefore can alleviate a misalignment phenomenon caused by displacement of the battery cell, and can improve liquid injection efficiency.

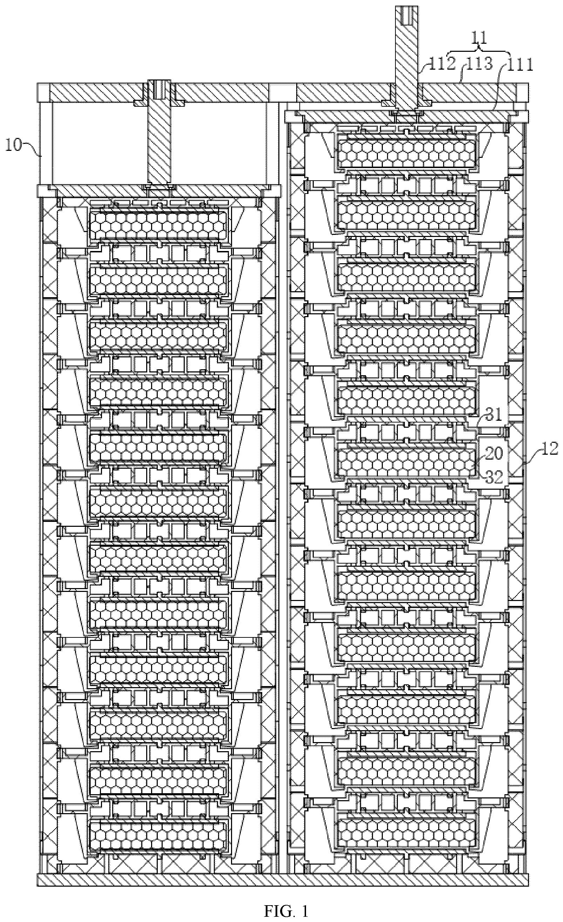

As shown in FIG. 1, FIG. 2, and FIG. 3, the spacer can be used in a tray assembly. The tray assembly includes a tray 10, a spacer 30, and a fastening block 12. The spacer 30 and the fastening block 12 are both provided on the tray 10. The spacer 30 is connected to the fastening block 12. The tray 10 is configured to support the spacer 30, a battery cell 20, and the fastening block 12. The fastening block 12 is configured to limit a position of the spacer 30. When the tray assembly is moved, the spacer 30, the fastening block 12, and the battery cell 20 can be moved simultaneously. A position of the battery cell 20 is limited on the spacer 30, so that the battery cell 20 remains in a predetermined state on the tray assembly, and the battery cell 20 can remain in an initial state as far as possible when the tray assembly is moved as a whole. In this way, a state of the battery cell 20 is determined before a corresponding process operation is performed, and the battery cell 20 can be also in the predetermined state during the corresponding process operation, to facilitate control on a position and a posture of the battery cell 20. In this example, the tray assembly may be provided with a plurality of spacers 30, and a battery cell 20 may be provided at a position corresponding to each spacer 30, so that a plurality of battery cells 20 can be moved simultaneously, to improve processing efficiency.

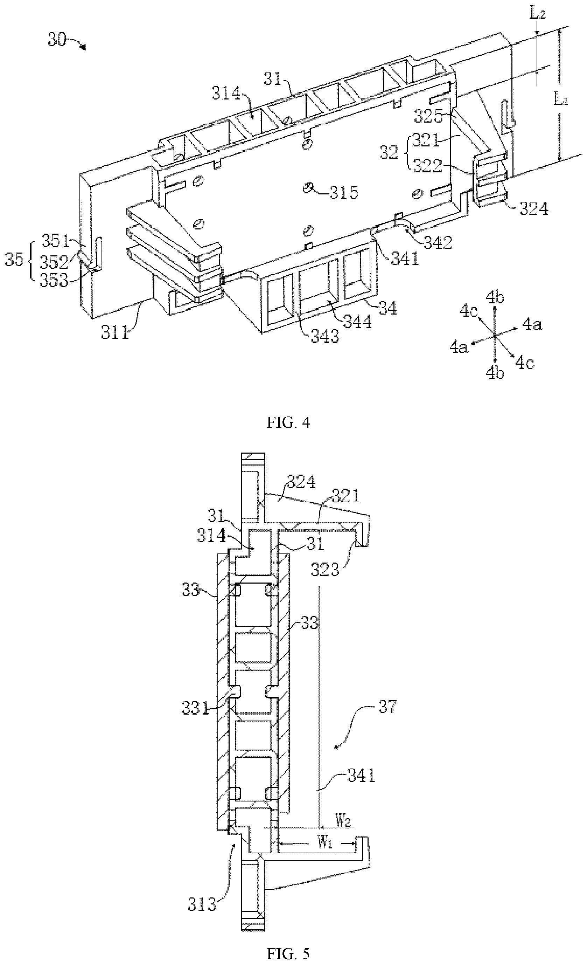

As shown in FIG. 4 and FIG. 5, in some examples, a spacer 30 for mounting a battery cell 20 is disclosed, and the spacer 30 includes a plate body 31 and a restraint member 32. The plate body 31 has a first surface 311. The restraint member 32 is connected to the plate body 31 and extends along a direction leaving the first surface 311. The restraint member 32 is configured to limit a position on an outer side of the battery cell 20, to block the battery cell 20 from moving along the direction leaving the first surface 311.

The spacer 30 is configured to limit a position of the battery cell 20. The spacer 30 may be generally in a cuboid shape. The first surface 311 is one of surfaces of the spacer 30. The first surface 311 is attached to one of end faces of the battery cell 20, to limit a position of the one of the end faces of the battery cell 20. The battery cell 20 may be in a cuboid shape, a cylindrical shape, or a prismatic shape, or the like In this example, the first surface 311 is provided toward one of surfaces of the battery cell 20. For ease of description, an example in which the battery cell 20 is in a cuboid structure is used below. The first surface 311 is provided toward one surface in a thickness direction of the battery cell 20. An end face on a side of the battery cell 20 that faces the first surface 311 is a first fitting surface of the battery cell 20. An end face on a side of the battery cell 20 that faces away from the first surface 311 is a second fitting surface of the battery cell 20. A side surface is present between the first fitting surface and the second fitting surface of the battery cell 20.

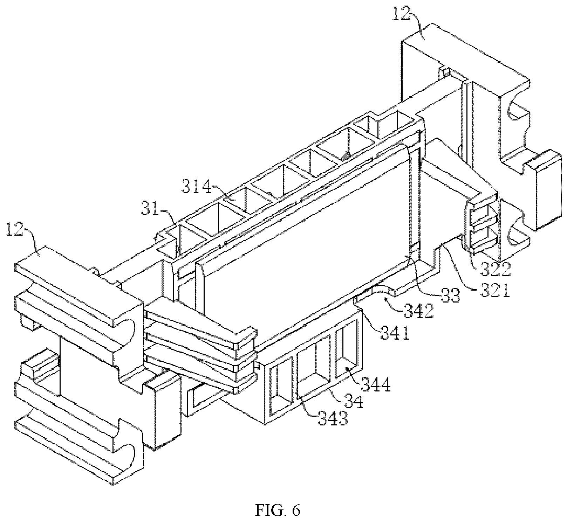

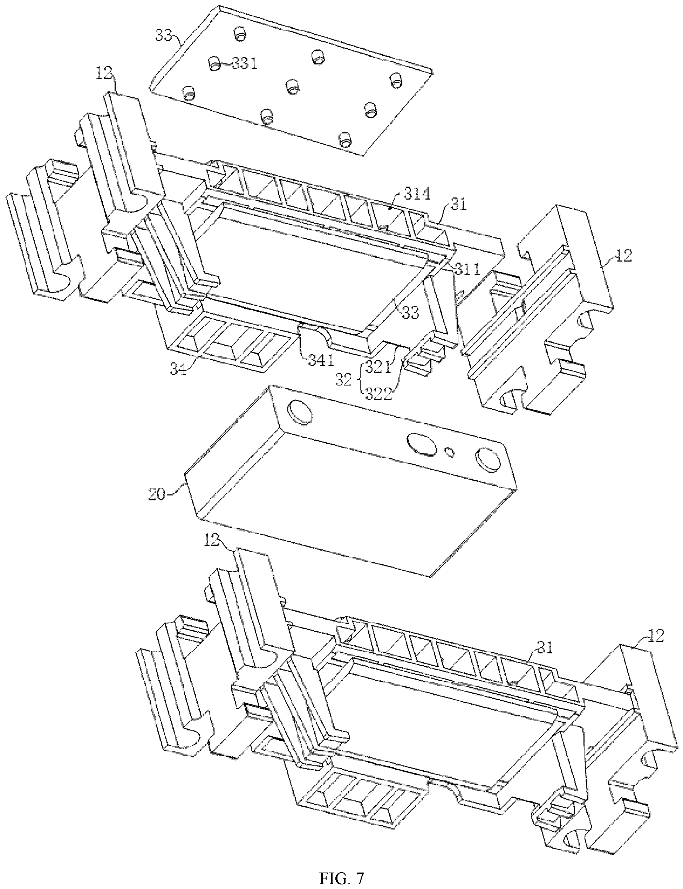

As shown in FIG. 6 and FIG. 7, the restraint member 32 is connected to the plate body 31. That the restraint member 32 is connected to the plate body 31 means that the restraint member 32 is fastened to any position on the plate body 31. In this example, the restraint member 32 may be directly connected to the first surface 311 of the plate body 31, or may be fastened to another surface of the plate body 31. For ease of description, an example in which the restraint member 32 is connected to the first surface 311 of the plate body 31 is used below for description. The restraint member 32 has a near end for connecting to the plate body 31, and a far end away from the plate body 31. The near end of the restraint member 32 is connected to the first surface 311 and extends along the direction leaving the first surface 311. A specific distance is present between the far end of the restraint member 32 and the first surface 311, so that the far end of the restraint member 32 can be used to limit a position of the side surface of the battery cell 20 or the second fitting surface of the battery cell 20.

In this example, that the restraint member 32 is configured to limit a position on an outer side of the battery cell 20 means that the restraint member 32 can block the second fitting surface and/or the side surface of the battery cell 20, to block the battery cell 20 from moving along the direction leaving the first surface 311.

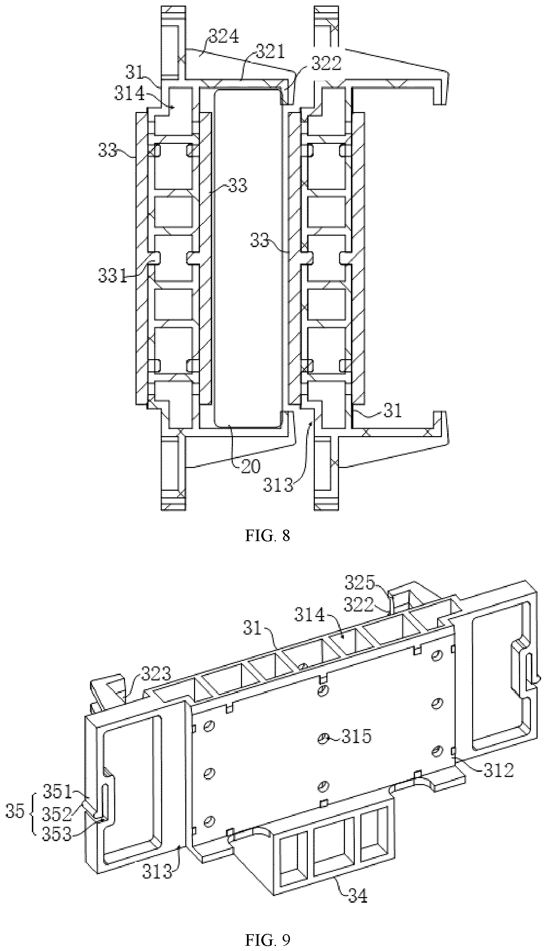

As shown in FIG. 7 and FIG. 8, in this example, the restraint member 32 blocks the battery cell 20 from moving along the direction leaving the first surface 311, so that the restraint member 32 can fit with the plate body 31, to limit a position of the battery cell 20 on a side of the first surface 311 of the plate body 31, and reduce movement of the battery cell 20 along a direction leaving the plate body 31.

In some examples, the restraint member 32 is configured to limit a position on the second fitting surface of the battery cell 20, so that the restraint member 32 and the first surface 311 correspondingly block two opposite outer surfaces of the battery cell 20 respectively. Because a gap between the restraint member 32 and the first surface 311 can form a mounting position 37 for limiting a position of the battery cell 20, the battery cell 20 cannot move along the direction leaving the first surface 311, so that a position of the battery cell 20 is limited on the spacer 30. In this way, unnecessary displacement of the battery cell 20 is reduced, and a possibility of fall-over of the battery cell 20 can also be reduced.

In some examples, the restraint member 32 is configured to limit a position on the side surface of the battery cell 20, so that the restraint member 32 applies a force to the side surface of the battery cell 20, to reduce movement of the battery cell 20 along the direction leaving the first surface 311.

In some examples, the restraint member 32 acts on both the second fitting surface and the side surface of the battery cell 20, to increase a fitting area between the restraint member 32 and the battery cell 20, and better limit a position of the battery cell 20.

In this example, the restraint member 32 blocks the battery cell 20, to reduce a possibility of movement of the battery cell 20 along the direction leaving the first surface 311. In some examples, the restraint member 32 is in face contact with the battery cell 20. The restraint member 32 has a restraint surface 323. The restraint surface 323 is attached to an outer surface of the battery cell 20, so that the restraint member 32 can block the battery cell 20 from moving along the direction leaving the first surface 311. In some examples, the restraint member 32 is in line contact or point contact with the battery cell 20, and the far end of the restraint member 32 may be in a hook-like structure or the like, so that the restraint member 32 can be in line contact or point contact with the battery cell 20.

In some examples, the restraint member 32 is generally in an L shape, an end of the L shape of the restraint member 32 is connected to the plate body 31, and another end of the L shape of the restraint member 32 blocks the second fitting surface of the battery cell 20, to block the battery cell 20 from moving along the direction leaving the first surface 311.

In some examples, the restraint member 32 is generally in a hook-like shape, and a hook portion of the restraint member 32 is hooked to the second fitting surface or the side surface of the battery cell 20.

In some examples, the restraint member 32 is in a form of a combination of a hook-like structure and an L-shaped structure, so that the restraint member 32 can limit positions of both the second fitting surface and the side surface of the battery cell 20.

Still as shown in FIG. 4 and FIG. 7, in some examples, the battery cell 20 is in a cuboid structure, a length direction of the battery cell 20 is a direction 4a in FIG. 4, a height direction of the battery cell 20 is a direction 4b in FIG. 4, a thickness direction of the battery cell 20 is a direction 4c in FIG. 4, and the restraint member 32 and the first surface 311 block two sides of the thickness direction of the battery cell 20 respectively. That the battery cell 20 moves along the direction leaving the first surface 311 means that the battery cell 20 moves along a direction leaving the plate body 31 along the direction 4c in FIG. 4.

As shown in FIG. 5, in some examples, the restraint member 32 is provided with a restraint surface 323, the restraint surface 323 is provided opposite to the first surface 311, and a mounting position 37 for mounting the battery cell 20 is formed between the restraint surface 323 and the first surface 311, so that the restraint surface 323 is configured to block the battery cell 20 from moving along the direction leaving the first surface 311.

The restraint surface 323 is a plane facing the first surface 311, and the mounting position 37 is formed between the restraint surface 323 and the first surface 311. The mounting position 37 is used for mounting the battery cell 20. After the battery cell 20 is placed in the mounting position 37, the first fitting surface of the battery cell 20 faces the first surface 311, and the second fitting surface of the battery cell 20 faces the restraint surface 323. The battery cell 20 can be blocked by both the first surface 311 and the restraint surface 323, so that the battery cell 20 cannot move toward an outer side of the mounting position 37.

In this example, the restraint surface 323 may be configured to block only positions at the two end in a length direction of the second fitting surface of the battery cell 20, or the restraint surface 323 may block any other position on the second fitting surface of the battery cell 20, provided that the restraint surface 323 can block the battery cell 20 from moving along the direction leaving the first surface 311.

In this example, the restraint member 32 may be generally in the L shape or the hook-like structure described in any one of the foregoing examples. The restraint surface 323 facing the first surface 311 is formed on the restraint member 32, so that the battery cell 20 is mounted in the gap between the restraint surface 323 and the first surface 311, and the restraint surface 323 blocks the battery cell 20 from moving along the direction 4c.

As shown in FIG. 4, FIG. 6, and FIG. 7, in some examples, the restraint member 32 includes a connecting section 321 and a restraint section 322. The connecting section 321 is connected to the plate body 31 and extends along the direction leaving the first surface 311. The restraint section 322 is connected to an end of the connecting section 321 that is away from the first surface 311, and is at an included angle with the connecting section 321. The restraint section 322 is provided with a restraint surface 323.

As shown in FIG. 5, in this example, the connecting section 321 and the restraint section 322 generally form an L-shaped structure, so that the restraint surface 323 facing the first surface 311 can be formed on the restraint section 322. When the connecting section 321 and the restraint section 322 are perpendicular to each other, the restraint member 32 including the connecting section 321 and the restraint section 322 is in an L-shaped structure.

The connecting section 321 is connected to the plate body 31, to serve as an intermediate connection portion between the restraint section 322 and the plate body 31. The restraint section 322 is configured to form the restraint surface 323 for blocking a side of the second fitting surface of the battery cell 20, to reduce a possibility of movement of the battery cell 20 along the direction leaving the first surface 311.

In some examples, the connecting section 321 is integrated with the restraint section 322. In some examples, the connecting section 321 and the restraint section 322 are provided separately, and are molded separately and then fastened to each other. In some examples, the connecting section 321 is integrated with the plate body, and the restraint section 322 is fastened to the connecting section 321 after the plate body and the connecting section 321 are molded through processing.

In some examples, the restraint section 322 is configured to block at least one end of the second fitting surface of the battery cell 20 in a length direction. In some examples, the restraint section 322 is configured to block at least one end of the second fitting surface of the battery cell 20 in a height direction. In some examples, the restraint section 322 blocks a position near the middle of the second fitting surface of the battery cell 20.

In some examples, at least two restraint sections 322 are provided on the connecting section 321, to form a plurality of restraint surfaces 323 on one side of the second fitting surface of the battery cell 20.

As shown in FIG. 4 to FIG. 9, in some examples, two restraint members 32 are provided, the two restraint members 32 are spaced apart, and restraint sections 322 of the two restraint members 32 separately extend along directions facing each other.

In this example, that the two restraint members 32 are spaced apart along the first direction 4a means that a gap capable of accommodating the battery cell 20 is formed between the two restraint members 32. The mounting position 37 is formed between the two restraint members 32, the first surface 311, and the restraint surface 323, so that the first fitting surface and the second fitting surface of the battery cell 20 are blocked by the first surface 311 and the restraint surface 323 respectively, and side walls of the battery cell 20 are blocked by the two restraint members 32 respectively. In this way, a position of the battery cell 20 is limited, and movement of the battery cell 20 along a direction leaving the plate body 31 is reduced.

As shown in FIG. 4, the first direction 4a may be a length direction of the battery cell 20, or may be a height direction of the battery cell 20. In this example, the first direction 4a is the length direction of the battery cell 20, the two restraint members 32 are located at two ends in the length direction of the battery cell 20 respectively, and the restraint sections of the two restraint members 32 separately extend along directions facing each other, so that the restraint sections of the two restraint members 32 separately block the second fitting surface of the battery cell 20. In this way, a position of the battery cell 20 is limited at the two ends in the length direction of the battery cell 20, and movement of the battery cell 20 along the direction leaving the first surface 311 is reduced.

Still as shown in FIG. 4, in some examples, the two restraint members 32 are spaced apart along the first direction 4a, the plate body 31 has a first end and a second end that are provided opposite to each other in the second direction 4b, the restraint member 32 has a first end provided in the second direction 4b, and the first end of the restraint member 32 is located on a same side of the spacer 30 as the first end of the plate body 31. The first end of the plate body 31 extends beyond the first end of the restraint member 32 along the second direction 4b, where the second direction 4b intersects with the first direction 4a. A distance between the first end of the restraint member 32 and the second end of the plate body 31 is less than a distance between the first end and the second end of the plate body 31. In some examples, the second direction 4b is perpendicular to the first direction 4a.

In this example, that the second direction 4b is at an included angle with the first direction 4a means that the second direction 4b is not parallel to the first direction 4a. In this example, the second direction 4b may be consistent with the height direction of the battery cell 20. Further, in some examples, the second direction may be perpendicular to the first direction.

The first end and the second end of the plate body 31 are provided opposite to each other in the second direction 4b. For ease of description, an example in which the first end and the second end of the plate body 31 in the second direction 4b are an upper end and a lower end of the plate body 31 is used below for description.

The distance between the first end and the second end of the plate body 31, namely, Li, is a height of the plate body 31. The first end of the restraint member 32 is an upper end of the restraint member 32. The distance between the first end of the restraint member 32 and the first end of the plate body 31 is L₂. The distance between the first end of the restraint member 32 and the second end of the plate body 31 is L₁ - L₂. In this example, the distance between the first end of the restraint member 32 and the second end of the plate body 31 is less than the distance between the first end and the second end of the plate body 31, that is, an upper end face of the plate body 31 is higher than an upper end face of the restraint member 32. A specific margin is present between the top of the restraint member 32 and the upper end face of the plate body 31.

During mounting of the battery cell 20 in the mounting position 37, a gripping apparatus may be placed above the restraint member 32, to be specific, on a side that is of the first end of the restraint member 32 and that is away from the first end of the plate body 31, and side walls of the battery cell 20 are gripped by the gripping apparatus, to grip and move the battery cell 20 along the second direction 4b.

Still as shown in FIG. 4, in some examples, the distance between the first end and the second end of the plate body 31 is Li, the distance between the first end of the restraint member 32 and the first end of the plate body 31 is L₂, and 0.2L₁ ≤ L₂ ≤ 0.3L₁.

Assuming that the second direction 4b in this example is an up-down direction, that the distance between the first end of the restraint member 32 and the first end of the plate body 31 is L₂ means that a height difference between the upper end face of the restraint member 32 and the upper end face of the plate body 31 is L₂. In addition, the distance between the first end of the restraint member 32 and the first end of the plate body 31 L₂ is 20% to 30% of the height Li of the plate body 31, so that the gripping apparatus can have sufficient gripping space. The bottom of the battery cell 20 is located on a side of the first end of the plate body 31, and the height direction of the battery cell 20 is the second direction 4b.

In this example, when L₂ is less than 0.2L₁, a height of the upper end face of the restraint member 32 is excessively large. Consequently, space for accommodating the gripping apparatus is excessively small, and the gripping apparatus is prone to falling-off. When L₂ is greater than 0.3L₁, space above the restraint member 32 is excessively large. This means that a height of the upper end face of the restraint member 32 is small. During fitting between the restraint member 32 and the battery cell 20, a maximum height of a contact surface between the restraint member 32 and the battery cell 20 is small. Consequently, the battery cell 20 is prone to tilting.

In some examples, the restraint surface 323 is parallel to the first surface 311. When the battery cell 20 is mounted in the mounting position 37 between the restraint surface 323 and the first surface 311, the restraint surface 323 and the first surface 311 can simultaneously act on the first fitting surface and the second fitting surface of the battery cell 20. When the battery cell 20 is in a cuboid structure, both the restraint surface 323 and the first surface 311 can be in surface contact with the battery cell 20, to improve stability of the battery cell 20.

In some examples, the restraint member 32 is integrated with the plate body 31, so that the restraint member 32 and the plate body 31 can be integrally molded, thereby facilitating molding and processing of the spacer 30. In this example, the spacer 30 may be integrally molded through injection molding or in another integral molding manner.

Still as shown in FIG. 4, in some examples, a first stiffener 324 is provided on a side of the restraint member 32 that faces away from the first surface 311. In this example, the first stiffener 324 is configured to reinforce and support the restraint member 32, to reduce a possibility of deformation or displacement of the restraint member 32.

In some examples, the restraint member 32 includes the connecting section 321 and the restraint section 322 in any one of the foregoing examples, and the first stiffener 324 is provided on a side of the connecting section 321 and/or the restraint section 322 that faces away from the first surface 311, to improve structural strength of the restraint member 32.

In some examples, the first stiffener 324 is a stiffening rib provided on the restraint member 32. In some examples, the first stiffener 324 is a support rod, a support plate, or another structure capable of providing support and reinforcement that is connected to the restraint member 32.

In some examples, at least one edge of the restraint member 32 is provided with a first chamfer 325. In this example, the restraint member 32 is provided with the first chamfer 325, to reduce damage caused by the edge of the restraint member 32 to the battery cell 20 during molding.

The first chamfer 325 is provided, so that a possibility that a defect such as a burr on the edge of the restraint member 32 causes damage to the battery cell 20 can be reduced during mounting or removal of the battery cell 20. When injection molding is performed, the first chamfer 325 can facilitate mold opening, to reduce injection molding defects.

In some examples, the restraint member 32 has a first end along the second direction 4b, the battery cell 20 moves from a side of the first end of the restraint member 32 toward the mounting position 37 along the second direction 4b, and the first chamfer 325 is provided at an edge position on a side, near the mounting position 37, of the first end of the restraint member 32. In this example, the first chamfer 325 may be a flat chamfer, or the first chamfer 325 may be a rounded chamfer.

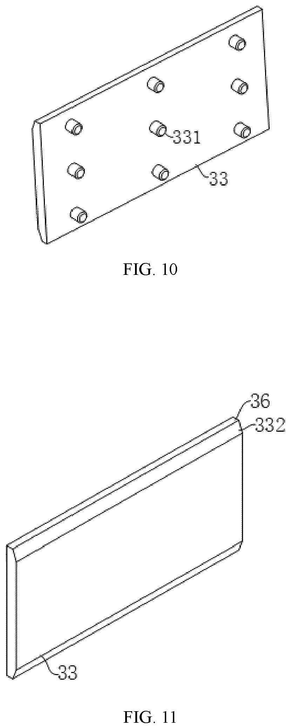

As shown in FIG. 4 and FIG. 9, in some examples, the plate body 31 further has a second surface 312, the second surface 312 is provided opposite to the first surface 311 along the third direction 4c, and the third direction 4c is the thickness direction of the plate body 31. As shown in FIG. 10 and FIG. 11, in some examples, the spacer 30 further includes a cushion 33, and the second surface 312 is provided with the cushion 33.

In some examples, that the third direction 4c is at an included angle with the first direction 4a means that the third direction 4c is not parallel to the first direction 4a. The third direction 4c may be the thickness direction of the battery cell 20. When the first surface 311 faces the battery cell 20, the second surface 312 is a surface on a side facing away from the battery cell 20. Further, in some examples, the third direction 4c may be perpendicular to the first direction. When the height direction of the battery cell 20 is the second direction in any one of the foregoing examples, every two of the first direction, the second direction, and the third direction may be perpendicular to each other.

The cushion 33 is provided on the second surface 312, and the cushion 33 has an elastic cushioning function. In some examples, the cushion 33 is made of silicone, so that an elastic member can present an elastic cushioning effect.

As shown in FIG. 4 and FIG. 7, when a plurality of spacers 30 are arranged along the third direction 4c, a spacer 30 located in the front along the third direction 4c is a first spacer, a spacer 30 adjacent to the first spacer is a second spacer, and a first surface 311 of the first spacer faces a second surface 312 of the second spacer. When a battery cell 20 is mounted on the first spacer, a first fitting surface of the battery cell 20 faces the first surface 311 of the first spacer, and a second fitting surface of the battery cell 20 faces the second surface 312 of the second spacer. When the two adjacent spacers 30 are close to each other, a cushion 33 of the second spacer can provide elastic cushioning for the first spacer, to reduce rigid collision between the second spacer and the first spacer. When the cushion 33 is attached to the second fitting surface of the battery cell 20, the cushion 33 can directly provide cushioning for the battery cell 20, to reduce indentation caused by the second spacer directly acting on the second fitting surface of the battery cell 20, and also reduce damage caused by rigid collision to the battery cell 20.

In some examples, the cushion 33 is in a layered structure, and the cushion 33 is laid on the second surface 312 of the spacer 30. In some examples, the cushion 33 is in a protrusion structure.

As shown in FIG. 9 and FIG. 10, one of the plate body 31 and the cushion 33 is provided with a positioning hole 315, the other is provided with a boss 331, and the boss 331 is inserted into the positioning hole 315. In this example, the cushion 33 and the plate body 31 are connected through fitting between the positioning hole 315 and the boss 331. In some examples, the plate body 31 is provided with a positioning hole 315, and the cushion 33 is provided with a boss 331. In some examples, the plate body 31 is provided with a boss 331, and the cushion 33 is provided with a positioning hole 315. In some examples, the plate body 31 and the cushion 33 each are provided with a boss 331 and a positioning hole 315. A boss 331 of the cushion 33 is inserted into a positioning hole 315 on the plate body 31, and a boss 331 on the plate body 31 is inserted into a positioning hole 315 on the cushion 33.

In some examples, a length of the cushion 33 along the first direction 4a is not greater than a minimum distance between two restraint members 32, and when two adjacent spacers 30 are pressed against each other, the cushion 33 can be placed between the two restraint members 32. In this case, the cushion 33 can act on the second fitting surface of the battery cell 20, to elastically limit a position of the second fitting surface of the battery cell 20.

In some examples, two restraint members 32 are spaced apart along the first direction 4a, and the restraint member 32 includes the connecting section 321 and the restraint section 322 in any one of the foregoing examples, and cushions 33 on adjacent spacers 30 can be inserted between restraint sections 322 of the two restraint members 32, so that the cushions 33 elastically limit a position of the battery cell 20 when the adjacent spacers 30 are pressed against each other.

In some examples, at least one edge part of the cushion 33 is provided with a second chamfer 332. In this example, the second chamfer 332 is provided on the cushion 33, thereby facilitating molding and processing for the cushion 33, and reducing processing defects. Further, in this example, at least one end of the cushion 33 in the second direction 4b is provided with the second chamfer 332, and the second chamfer 332 is provided facing away from the plate body 31. In this way, when the battery cell 20 is placed along the second direction 4b, the battery cell 20 can be guided by the second chamfer 332, to avoid the following problem: When an edge part of the cushion 33 has a right angle, the battery cell 20 directly presses against the right angle part of the cushion 33, and due to blocking of the right angle part, the cushion 33 falls off under the extrusion by the battery cell 20.

As shown in FIG. 11, further, in some examples, the restraint member is provided at an end of the plate body in the first direction, and the cushion 33 has an inner surface facing the plate body 31 and an outer surface facing away from the plate body 31. The cushion 33 further has a first outer wall 36 provided in the second direction 4b, where the second direction 4b intersects with the first direction 4a. The inner surface of the cushion 33 is connected to the first outer wall 36, and the second chamfer 332 is provided between the first outer wall 36 and the outer surface of the cushion 33. In a projection in the second direction 4b, a length of a projection of the second chamfer 332 is greater than a length of a projection of the first outer wall 36.

In this example, the second chamfer 332 may be a flat chamfer or a rounded chamfer. The length of the projection of the second chamfer 332 is greater than the length of the projection of the first outer wall 36. Therefore, when the battery cell 20 is placed along the second direction 4b, the battery cell 20 enters the mounting position 37 along the second chamfer 332, to alleviate a problem that the cushion 33 tends to move simultaneously with the battery cell 20 along the second direction 4b when the battery cell 20 directly acts on the first outer wall 36, and reduce a possibility that the cushion 33 falls off from the plate body 31.

In some examples, a thickness of the cushion 33 along the third direction 4c is not less than 5 mm and not greater than 10 mm. In this example, the thickness of the cushion 33 is 5 mm to 10 mm, and the thickness of the cushion 33 is directly proportional to a thickness of the battery cell 20 with an increase of the thickness of the battery cell 20, so that the cushion 33 can provide a good elastic cushioning effect to reduce problems such as indentation or rupture when the battery cell 20 is pressed against. In this example, the cushion 33 may be 5 mm, 6 mm, 7 mm, 8 mm, 9 mm, 10 mm, or any other thickness value within the foregoing range.

Still as shown in FIG. 7 and FIG. 8, in some examples, the first surface 311 is provided with a cushion 33, and the cushion 33 on the first surface 311 is configured to elastically limit a position of the first fitting surface of the battery cell 20, to reduce indentation or damage to the first fitting surface of the battery cell 20 under pressure. In this example, a shape, a size, and a mounting method of the cushion 33 on the first surface 311 may be the same as those of the cushion 33 in any one of the foregoing examples. Details are not described herein again.

After the battery cell 20 is mounted in the mounting position 37, the cushion 33 acts on both the first fitting surface and the second fitting surface of the battery cell 20. When adjacent spacers 30 are pressed against each other, cushions 33 on the adjacent spacers 30 provide elastic cushioning for the battery cell 20, to reduce deformation caused by pressure during processing when the battery cell 20 is clamped, and also reduce indentation caused by extrusion to the battery cell 20 to avoid impact on product appearance.

After the battery cell 20 is mounted in the mounting position 37, the cushion 33 on the first surface 311 occupies specific space in the mounting position 37, and the cushion 33 on the first surface 311 can press against the battery cell 20, so that the battery cell 20 is subject to an elastic force that presses against the battery cell 20 in a direction toward the restraint surface 323. This can reduce a possibility that the battery cell 20 falls off from the spacer 30, and can also reduce a possibility that the battery cell 20 shakes, thereby improving stability of the battery cell 20.

As shown in FIG. 8 and FIG. 9, in some examples, the plate body 31 further has a second surface 312, the second surface 312 is provided opposite to the first surface 311 along the third direction 4c, and the third direction 4c is the thickness direction of the plate body 31. The second surface 312 is provided with an avoidance groove 313. In a projection in the third direction 4c, a projection of the restraint section 322 falls within a projection of the avoidance groove 313.

In this example, the avoidance groove 313 is a groove provided on the second surface 312 of the plate body 31 for accommodating restraint members 32 on adjacent spacers 30 when a plurality of spacers 30 are mounted in combination along the third direction 4c. In some examples, every two of the third direction 4c, the first direction 4a, and the second direction 4b are perpendicular to each other.

In this example, the third direction 4c may be the thickness direction of the plate body 31. Along the third direction 4c, a spacer 30 located in the front is a first spacer, a spacer 30 located at the back is a second spacer, and a restraint section of a restraint member 32 of the first spacer located in the front can be placed in an avoidance groove 313 of the second spacer located at the back. In this way, when the first spacer and the second spacer are mounted in combination along the third direction 4c, a distance between a first surface 311 of the first spacer and a second surface 312 of the second spacer is reduced. Further, in some examples, the cushion 33 is provided on the second surface 312 of the second spacer, and a length of the cushion 33 in the first direction 4a is less than a minimum distance between two restraint members 32. When the first spacer and the second spacer are mounted in combination, a restraint section of the restraint member 32 protrudes on an outer side of the second fitting surface of the battery cell 20, and the restraint section of the restraint member 32 may be accommodated in the avoidance groove 313 of the second spacer. In this way, the cushion 33 on the second spacer can be elastically pressed onto the second fitting surface of the battery cell 20 through a gap between the two restraint members 32, so that the second fitting surface of the battery cell 20 is elastically pressed against the second spacer.

As shown in FIG. 4, FIG. 6, and FIG. 7, in some examples, the spacer 30 further includes a support member 34 connected to the plate body 31, the support member 34 is provided on a side of the plate body 31 along the second direction 4b, and an included angle is formed between the second direction 4b and the first direction 4a. In this example, the support member 34 can be used to support the plate body 31, so that the plate body 31 can be raised at a predetermined height position by the support member 34. In some examples, the second direction 4b is a height direction of the spacer 30, and the support member 34 is provided at the bottom of the plate body 31, so that the plate body 31 can be raised at the predetermined height position.

As shown in FIG. 4, in some examples, the support member 34 is provided with a first lightening hole 344, and the first lightening hole 344 is configured to enable the support member 34 to form a hollow structure, to reduce an overall weight of the support member 34. The first lightening hole 344 may be a via hole that penetrates the support member 34 along the second direction 4b, so that the first lightening hole 344 can form an airflow channel on a side of the spacer 30 in the second direction 4b, and the side of the spacer 30 in the second direction 4b can have an airflow channel, to control temperature of the battery cell 20. Further, in some examples, the first lightening hole 344 is a rectangular hole, so that wall thicknesses of side walls forming the first lightening hole 344 are close or equal, to improve structural strength of the support member 34 and reduce a possibility of deformation of the support member 34.

In some examples, the support member 34 is provided with a second stiffener 343, and the second stiffener 343 is provided in the first lightening hole 344. The second stiffener 343 is configured to support the support member 34, to reduce a possibility of deformation due to a force at a position at which the support member 34 is provided with the first lightening hole 344. In this example, the second stiffener 343 may be a stiffening rib, a stiffening plate, or another structure capable of providing reinforcement and support.

As shown in FIG. 4, in some examples, the support member 34 is further provided with a via hole 342, and the via hole 342 extends along the second direction 4b.

The via hole 342 penetrates the support member 34, so that space for an external structure to move toward the mounting position 37 along the second direction 4b can be formed on the support member 34. During processing of the battery cell 20, an external jacking structure may extend into the mounting position 37 through the second via hole 342, so that the external jacking structure can abut against the exterior of the battery cell 20 to push the battery cell 20 to move along the second direction 4b, thereby facilitating removal of the battery cell 20. There may be one or more via holes 342, and a position and a quantity of required via holes 342 may be determined based on a size of the battery cell 20.

In some examples, a width of the support member 34 in the third direction 4c is greater than a width of the plate body 31 in the third direction 4c, the third direction 4c is at an included angle with the second direction 4b, and a bearing surface 341 facing the mounting position 37 is formed on the support member 34. The bearing surface 341 of the support member 34 faces the mounting position 37, so that the bearing surface 341 can fit with a surface of the battery cell 20 in the second direction 4b, to limit a position of the surface of the battery cell 20 in the second direction 4b and reduce movement of the battery cell 20 along the second direction 4b. In this example, the bearing surface 341 may face a bottom surface of the battery cell 20, and a position of the bearing surface 341 is a lowest mounting position for the battery cell 20 on the spacer 30.

As shown in FIG. 4 and FIG. 5, in some examples, a minimum distance between the restraint surface 323 and the first surface 311 in the third direction 4c is W₁, and a width of the bearing surface 341 in the third direction 4c is W₂, where 0.8W₁ ≤ W₂ ≤ W₁. In this example, the width of the bearing surface 341 in the third direction 4c is limited. When the battery cell 20 is mounted in the mounting position 37, the bearing surface 341 acts on the surface of the battery cell 20 in the second direction 4b. When the width of the bearing surface 341 is excessively small, a contact area between the bearing surface 341 and the battery cell 20 is small, and the battery cell 20 is prone to tilting. When the width of the bearing surface 341 is greater than the minimum distance between the restraint surface 323 and the first surface 311, interference is likely to occur between adjacent spacers 30 in a state in which a plurality of spacers 30 are combined. In this example, the width of the bearing surface 341 is limited, so that mutual interference between adjacent spacers 30 can be reduced while the battery cell 20 is supported. This facilitates combination of a plurality of spacers 30, to simultaneously limit positions of a plurality of battery cells 20.

As shown in FIG. 4 and FIG. 5, in some examples, the plate body 31 is provided with a second lightening hole 314, and the second lightening hole 314 is configured to reduce a weight of the plate body 31, so that a structure of the spacer 30 is lighter. In this example, the second lightening hole 314 may be provided on an inner side of the plate body 31, and the second lightening hole 314 may penetrate the plate body 31, or the second lightening hole 314 may be provided on another surface, on the plate body 31, that does not need to be in contact with the battery cell 20.

In some examples, the second lightening hole 314 penetrates the plate body 31 along the second direction 4b, and the second direction 4b is at an included angle with the first direction 4a. The second lightening hole 314 penetrates the plate body 31, so that the second lightening hole 314 can form an airflow channel, to control temperature of the battery cell 20 when the air flows. The second direction 4b may be the thickness direction of the battery cell 20. When a plurality of spacers 30 are combined, air can be circulated through the second lightening hole 314, to control temperature of the plurality of battery cells 20.

In some examples, the second lightening hole 314 is a rectangular hole. In this example, the rectangular hole design is used, so that thicknesses of side walls forming the second lightening hole 314 can be the same, to improve overall structural strength of the plate body 31.

As shown in FIG. 1, this application further proposes an example of a tray assembly based on the foregoing examples of the spacer 30. The tray assembly includes a tray 10, the spacer 30 in any one of the foregoing examples, and a fastening block 12. The spacer 30 and the fastening block 12 are both provided on the tray 10. The spacer 30 is connected to the fastening block 12.

The tray 10 is configured to support the spacer 30, a battery cell 20, and the fastening block 12, to facilitate movement of the tray assembly as a whole.

In this example, the fastening block 12 limits the spacer 30 at a predetermined position on the tray 10. When the battery cell 20 is mounted on the spacer 30, if a position of the spacer 30 on the tray 10 is determined, a position of the corresponding battery cell 20 is also determined. When the position of the battery cell 20 needs to be moved, a position of the fastening block 12 may be moved to adjust the position of the spacer 30, so that the position of the battery cell 20 mounted on the spacer 30 can be simultaneously adjusted.

As shown in FIG. 4, FIG. 5, and FIG. 2, in some examples, one of the plate body 31 and the fastening block 12 is provided with a clamping groove 123, the other is provided with an elastic buckle 35, and the elastic buckle 35 is elastically clamped in the clamping groove 123. In this example, elastic clamping between the plate body 31 and the fastening block 12 is implemented through fitting between the elastic buckle 35 and the clamping groove 123, so that the spacer 30 is fastened to the fastening block 12.

The clamping groove 123 is a groove structure. The elastic buckle 35 can be elastically deformed under extrusion. When a force applied to the elastic buckle 35 disappears, the elastic buckle 35 is restored and is clamped in the clamping groove 123.

In some examples, the plate body 31 is provided with an elastic buckle 35, and the fastening block 12 is provided with a clamping groove 123. In some examples, the plate body 31 is provided with an elastic buckle 35, and the fastening block 12 is provided with a clamping groove 123. In some examples, the plate body 31 and the fastening block 12 each are provided with an elastic buckle 35 and a clamping groove 123. An elastic buckle 35 on the plate body 31 is elastically clamped into a clamping groove 123 on the fastening block 12, and an elastic buckle 35 on the fastening block 12 is elastically clamped into a clamping groove 123 on the plate body 31.

As shown in FIG. 4 and FIG. 9, in some examples, the plate body 31 is provided with an elastic buckle 35, the elastic buckle 35 includes an elastic beam 351 provided on the plate body 31, a clearance groove 353 is formed between the elastic beam 351 and a side wall of the plate body 31, and a clamping protrusion 352 is provided at an end of the elastic beam 351. When the plate body 31 is attached to the fastening block 12, the clamping protrusion 352 is pressed against by the fastening block 12, so that the clamping protrusion 352 drives the elastic beam 351 to be elastically deformed. The clearance groove 353 forms deformation space that allows elastic deformation of the elastic beam 351. When the clamping protrusion 352 moves into the clamping groove 123, the clamping protrusion 352 is clamped into the clamping groove 123. In this case, the elastic beam 351 is restored, and elastic resistance of the elastic beam 351 prevents the clamping protrusion 352 from being detached from the clamping groove 123, so that the elastic buckle 35 is elastically clamped into the clamping groove 123.

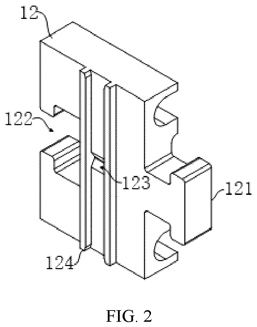

As shown in FIG. 2, the fastening block 12 is provided with a guide groove 124 on a side facing the plate body, and the plate body 31 is slidably disposed in the guide groove 124. After the plate body 31 is slidably disposed in the guide groove 124, the plate body 31 can move only along an extension direction of the guide groove 124, so that a position of the plate body 31 is limited in the guide groove 124. In this example, optionally, the guide groove 124 extends along the second direction, so that the guide groove 124 blocks displacement of the plate body 31 in other directions.

In some examples, the elastic buckle 35 is provided at an end of the plate body 31 in the first direction 4a, and the end of the plate body 31 in the first direction 4a can be inserted into the guide groove 124, so that the guide groove 124 is configured to limit movement of the end of the plate body 31 along the first direction 4a, and a position of the plate body 31 is limited by the guide groove 124.

As shown in FIG. 2, in some examples, the clamping groove 123 is provided on the fastening block 12, the fastening block 12 is provided with a guide groove 124 on a side facing the plate body 31, the guide groove 124 extends along the second direction 4b, the second direction 4b intersects with the third direction 4c, and the clamping groove 123 is provided in the guide groove 124.

The guide groove 124 is configured to limit a position of the elastic buckle 35, so that the elastic buckle 35 is clamped into the clamping groove 123 when the elastic buckle 35 moves to a position of the clamping groove 123 along an extension direction of the guide groove 124.

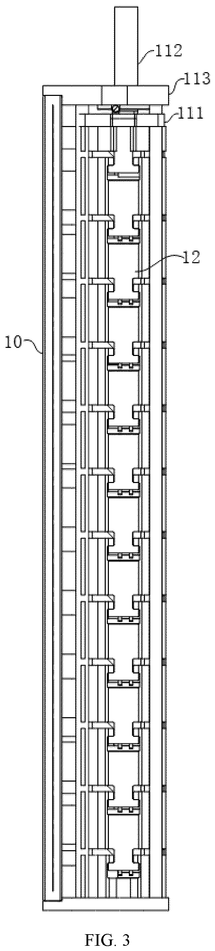

In this example, the guide groove 124 is provided, so that movement of the plate body 31 along a direction at an included angle with the second direction 4b can be limited by the guide groove 124. A direction shown in FIG. 3 is used as an example. The guide groove 124 can be used to prevent the plate body 31 from moving along the third direction 4c, to limit a position of the plate body 31.

As shown in FIG. 1 and FIG. 3, in some examples, the fastening block 12 is slidably disposed on the tray 10, so that the fastening block 12 forms a slider-like structure. When the fastening block 12 moves, the spacer 30 can be driven to move simultaneously with the corresponding fastening block 12, to adjust a position of the spacer 30.

As shown in FIG. 1, in some examples, a plurality of spacers 30 are provided, and the plurality of spacers 30 are sequentially provided in the third direction 4c. A plurality of fastening blocks 12 are provided, and each spacer 30 has at least one fastening block 12 connected thereto. The tray assembly further includes a drive member 11 provided on the tray 10, and the drive member 11 is configured to drive the fastening block 12 to move along the third direction.

In this example, each spacer 30 has at least one fastening block 12 connected thereto. For example, as shown in FIG. 7 and FIG. 1, each spacer 30 has two fastening blocks 12 connected thereto, and the two fastening blocks 12 limit positions of two sides of the spacer 30 in the second direction 4b. The plurality of spacers 30 are sequentially provided in the third direction, so that the spacers 30 cooperate with each other. When the drive member 11 drives the fastening block 12 to move along the third direction, the drive block drives a corresponding spacer 30 to move simultaneously along the third direction, to adjust a position of the spacer 30.

Because the spacer 30 is connected to the fastening block 12, the spacer 30 can move simultaneously with the fastening block 12 when the drive member 11 drives the fastening block 12 to move.

In some examples, the drive member 11 includes an end plate 113, a push plate 111, and a drive rod 112. The end plate 113 is connected to the fastening block 12, to push the fastening block 12 to move along the third direction. The drive rod 112 is connected to the push plate 111, and the push plate 111 is connected to the end plate 113, so that the push plate 111 can drive the end plate 113 to move synchronously when the drive rod 112 pushes the push plate 111 to move along the third direction. In some examples, the drive member 11 further includes a motor or a cylinder, and the motor or the cylinder serves as a power component. The motor is used as an example. The motor drives the drive rod 112 to move along the third direction, so that the fastening block 12 moves along the third direction.

As shown in FIG. 1 and FIG. 2, in some examples, the fastening block 12 has a first end and a second end that are provided in the third direction, the first end of the fastening block 12 is provided with a convex portion 121, the second end of the fastening block 12 is provided with a concave portion 122, and the convex portion 121 of the fastening block 12 is inserted into a concave portion 122 of an adjacent fastening block 12. In this example, the fastening block 12 is used for fitting between adjacent fastening blocks 12. During fitting of two fastening blocks 12, a convex portion 121 of one of the fastening blocks 12 is inserted into a concave portion 122 of an adjacent fastening block 12, to reduce relative movement of the adjacent fastening blocks 12 along the second direction 4b. In some examples, the concave portion 122 is a groove with a T-shaped contour, and the convex portion 121 is a protrusion with a T-shaped contour. When the convex portion 121 is inserted into the concave portion 122, the convex portion 121 is clamped into the concave portion 122.

It should be noted that the example of the tray assembly in this application is based on the examples of the spacer 30. Therefore, the example of the tray assembly in this application includes all the technical solutions in all the examples of the spacer 30, with exactly the same technical effects achieved. Details are not described herein again.

Based on the tray assembly, this application further proposes an example of a battery processing device. The battery processing device includes the tray assembly in any one of the foregoing examples. The battery processing device may be a formation processing device or another processing device. Because a position of a battery cell 20 can be limited in a spacer 30 by a restraint member 32, a possibility that the battery cell 20 falls off from the spacer 30 can be reduced, and therefore stability of the battery cell 20 during processing can be improved.

As shown in FIG. 1 to FIG. 11, in some examples, a spacer 30 for limiting a position of a battery cell 20 is disclosed, and the spacer 30 includes a plate body 31 and a restraint member 32 provided on the plate body 31. The plate body 31 has a first surface 311 and a second surface 312, and the first surface 311 and the second surface 312 are two surfaces provided in a thickness direction of the plate body 31. A cushion 33 is provided on each of the first surface 311 and the second surface 312. In this way, when two spacers 30 are combined, two opposite surfaces of the battery cell 20 can be respectively attached to cushions 33 on the two spacers 30, to elastically press against the battery cell 20 through the cushions 33, and reduce deformation of a surface of the battery cell 20 due to pressure. The restraint member 32 has a restraint surface 323, and the restraint surface 323 is provided opposite to the first surface 311. In this way, when the battery cell 20 is mounted on the spacer 30, the battery cell 20 is limited in a mounting position 37 between the first surface 311 and the restraint surface 323, thereby reducing a possibility of displacement or tilting of the battery cell 20. An avoidance groove 313 is provided on the second surface 312 of the spacer 30. When two spacers 30 are provided adjacent to each other, the battery cell 20 is mounted in a mounting position 37 of one of the spacers 30, and cushions 33 on second surfaces 312 of the adjacent spacers 30 can elastically abut against an outer side of the battery cell 20, so that both spacers 30 act on the battery cell 20, to elastically press against the battery cell 20, and fasten the battery cell 20 at a predetermined position. In this example, a plurality of spacers 30 are sequentially provided in a third direction, to simultaneously limit positions of a plurality of battery cells 20, and fastening blocks 12 are configured to limit positions of the plurality of spacers 30, so that the plurality of spacers 30 can move simultaneously with the fastening blocks 12, and the plurality of spacers 30 are simultaneously pressed against.

The foregoing descriptions are merely some optional examples of this application, but are not intended to limit the patent scope of this application. Any equivalent structural transformations made by using the content of the specification and drawings of this application, or direct or indirect application of the content of the specification and drawings in other related technical fields shall fall within the patent protection scope of this application.

## Claims

1. A spacer for mounting a battery cell, wherein the spacer comprises:
a plate body, wherein the plate body has a first surface; and
a restraint member, connected to the plate body and extending along a direction leaving the first surface, wherein the restraint member is configured to limit a position on an outer side of the battery cell, to block the battery cell from moving along the direction leaving the first surface.

2. The spacer according to claim 1, wherein the restraint member comprises:
a connecting section, connected to the plate body and extending along the direction leaving the first surface; and
a restraint section, connected to an end of the connecting section that is away from the first surface, and at an included angle with the connecting section, wherein the restraint section is provided with a restraint surface, a mounting position for mounting the battery cell is formed between the restraint surface and the first surface, and the restraint surface is configured to block the battery cell from moving along the direction leaving the first surface.

3. The spacer according to claim 2, wherein two restraint members are provided, and the two restraint members are spaced apart; and
restraint sections of the two restraint members separately extend along directions facing each other.

4. The spacer according to claim 3, wherein the two restraint members are spaced apart along a first direction, the plate body has a first end and a second end that are provided opposite to each other in a second direction, the restraint member has a first end provided in the second direction, and the first end of the restraint member is located on a same side of the spacer as the first end of the plate body; and
the first end of the plate body extends beyond the first end of the restraint member along the second direction, wherein the second direction intersects with the first direction.

5. The spacer according to claim 4, wherein a distance between the first end and the second end of the plate body is L₁, a distance between the first end of the restraint member and the first end of the plate body is L₂, and 0.2Li ≤ L₂ ≤ 0.3L₁.

6. The spacer according to any one of claims 2 to 5, wherein the restraint surface is parallel to the first surface.

7. The spacer according to any one of claims 1 to 6, wherein the restraint member is integrated with the plate body.

8. The spacer according to any one of claims 1 to 7, wherein the plate body further has a second surface, the second surface is provided opposite to the first surface in a third direction, and the third direction is a thickness direction of the plate body; and
the spacer further comprises a cushion, and the first surface and/or the second surface is provided with the cushion.

9. The spacer according to claim 8, wherein at least one edge part of the cushion is provided with a second chamfer.

10. The spacer according to claim 9, wherein the restraint member is provided at an end of the plate body in the first direction, and the cushion has an inner surface facing the plate body and an outer surface facing away from the plate body;
the cushion further has a first outer wall provided in the second direction, wherein the second direction intersects with the first direction; and
the inner surface of the cushion is connected to the first outer wall, the second chamfer is provided between the first outer wall and the outer surface of the cushion, and in a projection in the second direction, a length of a projection of the first outer wall is less than a length of a projection of the second chamfer.

11. The spacer according to any one of claims 2 to 10, wherein the plate body further has a second surface, the second surface is provided opposite to the first surface in a third direction, and the third direction is a thickness direction of the plate body; and
the second surface is provided with an avoidance groove, and in a projection in the third direction, a projection of the restraint section falls within a projection of the avoidance groove.

12. The spacer according to any one of claims 3 to 11, wherein the two restraint members are spaced apart along the first direction; and the spacer further comprises:
a support member, connected to the plate body, wherein the support member is provided on a side of the plate body in the second direction, and an included angle is formed between the second direction and the first direction.

13. A tray assembly, comprising:
a tray;
the spacer according to any one of claims 1 to 12, provided on the tray; and
a fastening block, provided on the tray, wherein the spacer is connected to the fastening block.

14. The tray assembly according to claim 13, wherein one of the plate body and the fastening block is provided with a clamping groove, the other is provided with an elastic buckle, and the elastic buckle is elastically clamped in the clamping groove.

15. The tray assembly according to claim 13 or 14, wherein the fastening block is provided with a guide groove on a side facing the plate body, and the plate body is slidably disposed in the guide groove.

16. A battery processing device, comprising the tray assembly according to any one of claims 13 to 15.
